# FASCICULE DE BREVET EUROPEEN

(11) **EP 0 980 588 B1**
(45) Date de publication et mention de la délivrance du brevet: **26.02.2003**
(21) Numéro de dépôt: 98924367.0
(22) Date de dépôt: 04.05.1998
(51) Int. Cl.: H01L 29/76

(54) **DISPOSITIF A BASE D'ILOTS QUANTIQUES ET PROCEDE DE FABRICATION**
AUS QUANTENINSELN GEMACHTE ANORDNUNG UND VERFAHREN ZUR HERSTELLUNG
DEVICE BASED ON QUANTIC ISLANDS AND METHOD FOR MAKING SAME

(30) Priorité: 05.05.1997 FR 9705506
(43) Date de publication de la demande: 23.02.2000
(73) Titulaire: COMMISSARIAT A L'ENERGIE ATOMIQUE, 75015 Paris (FR)
(72) Inventeur: GAUTIER, Jacques, F-38500 Coublevie (FR); MARTIN, François, F-38000 Grenoble (FR)
(74) Mandataire: Poulin, Gérard
(86) Numéro de dépôt international: FR9800889
(87) Numéro de publication internationale: WO98050958

(56) Documents cités:
- EP-A- 0 750 353
- PATENT ABSTRACTS OF JAPAN vol. 95, no. 11, 26 décembre 1995 & JP 07 226522 A (HITACHI LTD), 22 août 1995
- KANUO YANO ET AL: "ROOM-TEMPERATURE SINGLE-ELECTRON MEMORY" IEEE TRANSACTIONS ON ELECTRON DEVICES, vol. 41, no. 9, 1 septembre 1994, pages 1628-1638, XP000466806 cité dans la demande
- TIWARI S ET AL: "A SILICON NANOCRYSTALS BASED MEMORY" APPLIED PHYSICS LETTERS, vol. 68, no. 10, 4 mars 1996, pages 1377-1379, XP000582303 cité dans la demande
- H. SASAKI MOMOSE ET AL.: "High-frequency AC characteristics of 1.5nm gate oxide MOSFETs" INTERNATIONAL ELECTRON DEVICES MEETING 1996 TECHNICAL DIGEST, 8 - 11 décembre 1996, pages 105-108, XP002052597 SAN FRANCISCO,CA, US cité dans la demande

## Description

### Domaine technique et art antérieur

Le domaine technique concerné par cette invention est celui des dispositifs à effet quantique mettant en oeuvre le phénomène de blocage de Coulomb. Elle vise notamment les applications mémoires et logiques de circuits intégrés de très haute densité, réalisés sur substrat de silicium.

Le principe et la faisabilité de tels dispositifs sont exposés par exemple dans l'article de K. Yano et al. Intitulé "Room-Temperature Single Electron Memory" paru dans IEEE Transactions on Electron Devices, vol. 41, n° 9, p. 1628-1638, 1994.

Le phénomène de blocage de Coulomb se produit dans des îlots conducteurs à la fois isolés diélectriquement de leur environnement et faiblement couplés à celui-ci par effet tunnel. La mise en oeuvre de ce phénomène à des températures proches de la température ambiante requiert que la capacité totale de chaque îlot soit de l'ordre de l'atto farad, ce qui, combiné avec l'existence d'un courant tunnel qui ne soit pas trop faible, impose que les dimensions des îlots soient dans la gamme du nanomètre.

La réalisation d'îlots conducteurs, ayant une dimension caractéristique de plus de 10 nm, a déjà été effectuée à l'aide de procédés conventionnels de lithogravure, poussés à leurs limites. Par contre, à l'échelle de quelques nanomètres, la résolution actuelle de tels procédés est dépassée.

Une solution mise en oeuvre consiste à effectuer un dépôt granulaire du matériau conducteur sur une couche isolante, par exemple par une technique de type CVD, ou par évaporation : ceci est par exemple décrit dans l'article de W. Chen et al. intitulé "Coulomb blockade at 77K in nanoscale metallic islands in a latéral nanostructure" paru dans Applied Physics Letters, vol. 66, n° 24, p. 3383-3384, 1995.

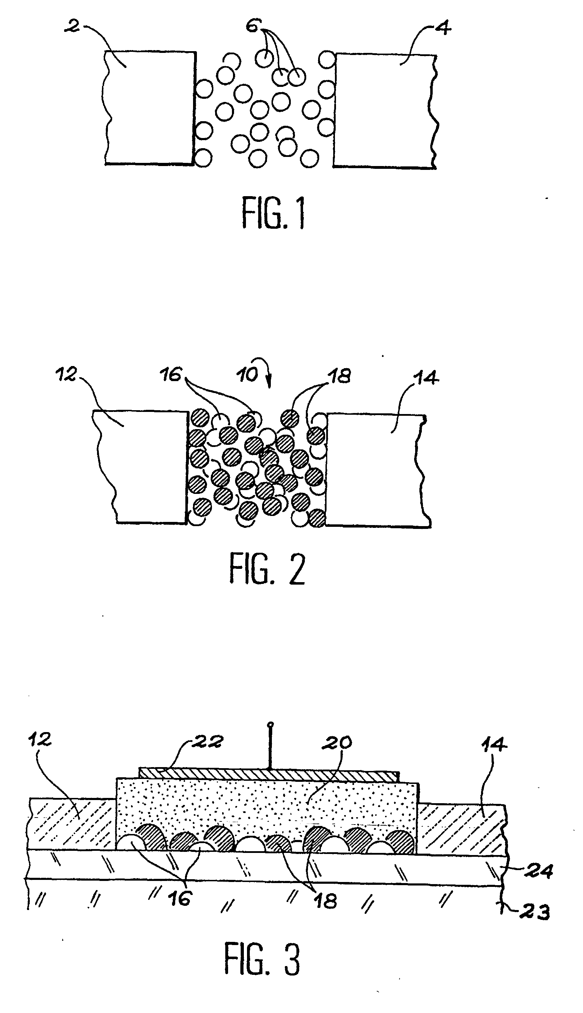

La zone contenant en final les îlots (fil ou rectangle) peut être délimitée par un procédé de lithogravure (lift off par exemple). La structure obtenue est représentée schématiquement sur la figure 1. Sur cette figure, les références 2 et 4 désignent deux réservoirs d'électrons (par exemple : source et drain d'un transistor), entre lesquels sont répartis les îlots nanométriques 6.

L'inconvénient majeur de cette approche est que les îlots 6 se placent aléatoirement, ce qui conduit à une forte dispersion des niveaux de courant tunnel d'un îlot à l'autre. Le courant global, entre deux électrodes placées de part et d'autre d'une zone d'îlots, est alors extrêmement sensible à la densité d'îlots, et les caractéristiques de ce courant sont très dispersées d'un échantillon à l'autre.

Il est également connu de l'art antérieur la demande de brevet EP 0 750 353 A2 qui concerne un dispositif à base d'ilôts quantiques ainsi qu'un procédé de fabrication d'un tel dispositif.

### Exposé de l'invention

La présente invention a pour objectif la réalisation d'un ensemble d'îlots permettant une amélioration de l'uniformité des caractéristiques, en particulier de courant, par rapport aux ensembles d'îlots obtenus par des procédés conventionnels.

L'invention a pour objet un dispositif à effet quantique, dont le fonctionnement met en oeuvre le phénomène de blocage de Coulomb, comportant :
- un premier et un second réservoirs d'électrons,
- au moins un premier et un second ensembles d'îlots séparés par une couche de diélectrique,
- une couche d'isolant de protection et une grille de contrôle.

L'invention a également pour objet un transistor comportant une source, un drain et une grille, ainsi qu'un canal reliant la source et le drain, un premier et un second ensembles d'îlots séparés l'un de l'autre par une couche de diélectrique, lesdits îlots étant répartis entre le canal et la grille, une couche d'isolant de protection recouvrant les deux ensembles d'îlots.

Par conséquent, selon l'invention, on comble partiellement l'espace entre les grains en les recouvrant d'une couche isolante (ou couche isolante tunnel, qui a pour rôle de fixer le niveau de courant (effet tunnel)), de préférence uniforme et d'épaisseur contrôlée, puis on comble l'espace restant par un second dépôt de grains. Les dépôts successifs d'îlots ne forment donc qu'une seule couche d'îlots.

Si la distance entre les premiers grains, surmontés de la couche isolante tunnel, est de l'ordre de grandeur de la taille des grains, deux dépôts successifs de grains sont suffisants pour obtenir une bonne uniformisation des propriétés électriques.

Si la distance entre les grains est supérieure à la taille des grains, plusieurs dépôts successifs de grains surmontés chacun d'une couche d'isolant tunnel (à l'exception de la dernière couche de grains) peuvent être réalisés. De préférence, les différentes couches d'isolant tunnel sont de même épaisseur.

L'invention concerne donc un dispositif microélectronique comportant une source et un drain, et des couches successives d'îlots ou de grains en nombre n≥2, chaque couche (sauf la dernière) étant surmontée d'une couche d'isolant tunnel. Une couche de diélectrique et une grille permettent de commander ce dispositif microélectronique.

L'invention permet d'améliorer les caractéristiques électriques des îlot ou des grains conducteurs situés entre les réservoirs d'électrons du dispositif à effet quantique, ou entre la source et le drain du transistor ou du dispositif microélectronique.

L'invention proposée permet d'améliorer l'uniformité d'épaisseur du diélectrique séparant les îlots et donc l'uniformité du courant tunnel, bien que le positionnement des îlots soit encore aléatoire.

Dans un dispositif à effet quantique selon l'invention, le niveau de courant tunnel varie exponentiellement avec l'épaisseur de la barrière mise en jeu. L'uniformisation du diélectrique entourant les îlots permet d'améliorer le courant tunnel.

La structure objet de l'invention (dispositif à effet quantique fonctionnant sur la base du phénomène de blocage de Coulomb, ou transistor ou dispositif microélectronique) comporte donc un ensemble d'îlots ou de grains séparés les uns des autres par un isolant, de préférence bien contrôlé en épaisseur, ce qui améliore l'uniformité du courant tunnel entre les grains. Une bonne uniformité du courant tunnel est obtenue avec un isolant d'épaisseur contrôlée.

L'invention a également pour objet un dispositif de mémorisation comportant un dispositif ou un transistor tel que décrit ci-dessus.

L'invention a également pour objet un procédé de réalisation d'un dispositif microélectronique, ou d'un transistor, ou d'un dispositif à effet quantique dont le fonctionnement met en oeuvre le phénomène de blocage de Coulomb, ou d'un dispositif de mémorisation, comportant les étapes suivantes :
a) la formation d'un premier et d'un second réservoirs d'électrons,
b) la formation d'un premier ensemble de grains ou d'îlots conducteurs,
c) la formation d'une couche de diélectrique par dessus le premier ensemble de grains ou d'îlots,
d) la formation d'un autre ensemble d'îlots ou de grains conducteurs, par dessus la couche de diélectrique.

Les étapes c) et d) peuvent être répétées N fois.

Puis, l'ensemble peut être recouvert d'une couche d'isolant de protection et d'une grille de contrôle.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- la figure 1 représente schématiquement une structure réalisée selon les techniques de l'art antérieur,
- les figures 2 et 3 représentent des vues de dessus et de côté de dispositifs réalisés selon les techniques de la présente invention.

### Description détaillée de modes de réalisation de l'invention

La figure 2 représente une vue de dessus d'un dispositif conforme à la présente invention.

Les références 12 et 14 désignent un premier et un second réservoirs d'électrons d'un dispositif 10 à effet quantique, dont le fonctionnement met en oeuvre le phénomène de blocage de Coulomb. Ces réservoirs sont par exemple le drain et la source d'une structure de type transistor, ou d'un dispositif microélectronique.

Entre ces deux éléments se trouve un ensemble 16, 18 d'îlots, ou de grains, conducteurs. Ceux-ci sont de préférence de taille nanométrique (par exemple comprise entre 1 et 10 nm ou entre 1 et 5 nm). Cet ensemble d'îlots, ou de grains, est en fait constitué d'un premier et d'un second sous-ensembles 16, 18, séparés par une couche de diélectrique.

Les espaces inter-îlots se trouvent donc statistiquement, soit comblés, soit réduits, d'un dépôt à l'autre.

En fait, on comble d'abord partiellement l'espace entre les îlots 16, ou les grains, du premier sous-ensemble, en les recouvrant d'une couche isolante, puis on comble l'espace restant par un second dépôt d'îlots 18 ou de grains.

La couche isolante, ou diélectrique, peut être obtenue par toute technique appropriée, en fonction de la nature du matériau conducteur : il s'agit par exemple de l'oxydation du matériau conducteur, ou d'une nitruration, ou encore du dépôt d'un matériau isolant.

De préférence, l'épaisseur de l'isolant est déterminée en fonction des critères suivants :
- épaisseur suffisamment faible pour que le courant tunnel soit suffisamment fort,
- résistance tunnel équivalente de cette couche d'isolant inférieure à la valeur h/e²=25kΩ,
- capacité de liaison la plus faible possible (la capacité de la structure dépend de la surface du grain et de l'épaisseur de l'isolant) pour pouvoir fonctionner à une température proche de la température habituelle. Par exemple, si les îlots, ou les grains, ont des diamètres de l'ordre de quelques nanomètres, on chercher à obtenir une capacité, par rapport à l'environnement, de 0,1 atto Farad à quelques atto Farad (par exemple 1 atto Farad).

L'isolant tunnel peut avoir une épaisseur comprise entre 0,7 nm et 3 nm (par exemple : 1 nm).

L'épaisseur finale du diélectrique inter-îlots ou inter-grains est définie par celle de la fine couche isolante, laquelle est plus uniforme que la distance inter-îlots ou inter-grains. Il en résulte une amélioration de l'uniformité du courant tunnel.

Le nombre de couches de dépôt granulaire est un paramètre variable. Ce nombre peut être fonction de la densité et de la dimension des îlots. Par exemple, si la distance entre les grains est supérieure à la taille des grains, plusieurs dépôts successifs (par exemple : 3, ou 4, ... etc.) de grains surmontés chacun d'une couche d'isolant tunnel permettront de réaliser une bonne couverture de l'espace entre les électrodes 12, 14.

Comme illustré sur la figure 3, l'ensemble d'îlots, ou de grains, peut ensuite être recouvert d'une couche 20 diélectrique et d'une grille de contrôle 22.

Un tel dispositif fonctionne de la manière décrite par exemple dans l'article de K. Yano et al., déjà cité dans l'introduction à la présente demande. L'application d'un potentiel V_{g} particulier (défini par les différentes capacités qui interviennent dans le système) permet de transférer, par effet tunnel, un électron du canal formé entre les réservoirs d'électrons 12, 14 à un îlot ou à un grain conducteur. Ce transfert est mis en évidence par une variation du courant drain. L'existence d'un phénomène d'hystérésis dans la capture d'un électron unique crée un effet de mémoire dans la cellule élémentaire ainsi constituée. Le dispositif selon l'invention peut donc être combiné avec, par exemple, des moyens de commande de la tension grille et des moyens de lecture du courant drain.

Un procédé de réalisation d'un dispositif selon l'invention comporte, après formation des électrodes, ou réservoirs d'électrons, 12, 14, la formation d'un premier ensemble de grains, ou d'îlots, conducteurs 16. Ceci peut être réalisé par dépôts granulaires minces de silicium amorphe (avec des grains de diamètre moyen 3 nm), puis traitement thermique, comme décrit dans l'article de K. Yano déjà cité ci-dessus, ou dans l'article de S. Tiwari et al., intitulé "Silicon nanocristals based memory", paru dans Applied Physics Letters, vol. 68, n°10, pages 1377-1379, 1996.

La couche diélectrique de séparation peut être ensuite réalisée par oxydation thermique partielle, comme décrit dans l'article de H. Sasaki Momose et al., intitulé "High-Frequency AC Characteristics of 1.5 nm Gate oxide MOSFETs", paru dans IEEE International Electron Devices Metting, pages 105-108, 1996.

On réalise ensuite un second dépôt granulaire mince de silicium polycristallin.

Ces étapes de dépôt et d'oxydation peuvent être répétées un certain nombre de fois. Puis, on forme une couche diélectrique 20 et on réalise une grille de contrôle 22.

Ces différentes étapes sont réalisées sur un substrat de départ 23 recouvert de diélectrique 24 (par exemple en Si₃N₄). Un dépôt épais de silicium polycristallin fortement dopé est ensuite réalisé. Par photolithographie, gravure de cette couche de silicium polycristallin et retrait de la résine, on réalise les électrodes 12, 14.

Par conséquent, selon l'invention, on enchaîne au moins deux étapes de dépôt granulaire de matériau conducteur : ainsi, les espaces inter-îlots se trouvent statistiquement, soit comblés, soit réduits, d'un dépôt à l'autre.

L'invention permet donc d'améliorer l'uniformité des caractéristiques électriques d'un ensemble îlots conducteurs situé entre la source et le drain de dispositifs micro-électronique. Ces caractéristiques sont améliorées, malgré un positionnement irrégulier des grains, ou des îlots.

## Revendications

1. Procédé de réalisation d'un dispositif à effet quantique ou d'un dispositif microélectronique, comportant les étapes suivantes :
a) la formation d'un premier et d'un second réservoirs d'électrons (12, 14),
b) la formation d'un canal entre le premier et le second réservoirs d'électrons, ce canal comprenant un premier ensemble de grains ou d'îlots conducteurs (16),
c) la formation d'une couche de diélectrique d'isolant tunnel par dessus l'ensemble d'îlots ainsi formé de façon à combler partiellement l'espace entre les îlots conducteurs,
d) la formation d'un second ensemble d'îlots conducteurs ou de grains conducteurs (18), par dessus la couche de diélectrique d'isolant tunnel de façon à combler l'espace restant non comblé par l'isolant tunnel, les deux ensembles d'îlots conducteurs étant situés sensiblement dans un même plan.

2. Procédé selon la revendication 1, **caractérisé en ce que** le premier et le second réservoirs d'électrons sont respectivement la source et le drain d'un même transistor.

3. Procédé selon l'une des revendications 1 ou 2, les étapes c) et d) étant répétées N fois.

4. Procédé selon l'une des revendications 1 à 3, comportant en outre la réalisation d'une couche isolante de protection (20) et d'une grille (22) de contrôle.

## Claims

1. Process for producing a quantic effect device or a microelectronic device, comprising the following steps:
a) formation a first and a second electron reservoirs (12, 14),
b) formation of a channel between the first and second electron reservoirs, said channel comprising a first set of conducting grains or islands (16),
c) formation of a tunnel insulating dielectric layer above the set of islands formed in this way, so as to partly fill the space between the conducting islands,
d) formation of a second set of conducting grains or islands (18) from above the tunnel insulating dielectric layer so as to fill the remaining space not filled by the tunnel insulant, the two sets of conducting islands being located substantially in the same plane.

2. Process according to claim 1, **characterized in that** the first and second electron reservoirs are respectively the source and drain of the same transistor.

3. Process according to one of the claims 1 and 2, the steps c) and d) being repeated N times.

4. Process according to any one of the claims 1 to 3, also comprising the production of a protective insulating layer (20) and a control grid (22).

## Patentansprüche

1. Verfahren zur Herstellung einer Vorrichtung mit Quanteneffekt oder einer mikroelektronischen Vorrichtung, das die folgenden Schritte umfasst:
a) die Bildung eines ersten und zweiten Elektronenspeichers (12, 14),
b) die Bildung eines Kanals zwischen dem ersten und dem zweiten Elektronenspeicher, wobei dieser Kanal eine erste Menge von leitenden Körnern oder Inseln (16) enthält,
c) die Bildung einer dielektrischen Tunnelisolatorschicht auf der Insel-Menge, derart ausgebildet, dass sie den Raum zwischen den leitenden Inseln partiell füllt,
d) die Bildung einer zweiten Menge leitender Inseln oder leitender Körner (18) auf der dielektrischen Tunnelisolatorschicht, derart, dass der nicht vom Tunnelisolator ausgefüllte restliche Raum gefüllt wird, wobei die beiden Mengen leitender Inseln sich im Wesentlichen in einer selben Ebene befinden.

2. Verfahren nach Anspruch 1, **dadurch gekennzeichnet, dass** der erste und der zweite Elektronenspeicher jeweils die Source und der Drain eines selben Transistors sind.

3. Verfahren nach einem der Ansprüche 1 oder 2, bei dem die Schritte c) und d) N-mal wiederholt werden.

4. Verfahren nach einem der Ansprüche 1 bis 3, das außerdem die Herstellung einer Schutzisolierschicht (20) und eines Steuergates (22) umfasst.
